# EUROPEAN PATENT SPECIFICATION

(11) **EP 3 664 590 B1**
(45) Date of publication and mention of the grant of the patent: **29.06.2022**
(21) Application number: 17919982.3
(22) Date of filing: 04.08.2017
(51) Int. Cl.: H05K 13/02, H05K 13/04

(54) **TAPE FEEDER**
BANDZUFÜHRER
DISPOSITIF D'INTRODUCTION DE BANDE

(43) Date of publication of application: 10.06.2020
(73) Proprietor: Fuji Corporation, Chiryu-shi, Aichi 472-8686 (JP)
(72) Inventor: TSUZUKI, Isao, Chiryu-shi Aichi 472-8686 (JP); ITO, Akinobu, Chiryu-shi Aichi 472-8686 (JP); SHIMIZU, Toshinori, Chiryu-shi Aichi 472-8686 (JP)
(74) Representative: Grünecker Patent- und Rechtsanwälte PartG mbB
(86) International application number: PCT/JP2017/028399
(87) International publication number: WO 2019/026279

(56) References cited:
- WO-A1-2017/098605
- JP-A- H 104 294
- JP-A- 2013 093 536
- JP-A- 2013 093 536
- JP-U- H0 294 854
- US-A- 5 050 650
- US-A1- 2017 042 073

## Description

### Technical Field

The present invention relates to a tape feeder for feeding lead components.

### Background Art

In a tape feeder for supplying lead components, lead components are supplied in a form of being separated from a carrier tape by cutting the leads at a carrier tape holding the leads of the lead components. A waste tape, in a state in which the radial components have been separated from the taped components by cutting the leads, is discharged to the outside of the tape feeder. The following patent literature describes a technique of discharging a waste tape to the outside of a tape feeder in a tape feeder for supplying an electronic component which is not a lead component and does not have leads.

Patent Literature 2 and Patent Literature 3 provide further tape feeders according to the prior art.

### Patent Literature

Patent Literature 1: JP-A-2008-205406
Patent Literature 2: JP 2013093536 A
Patent Literature 3: US 2017042073 A1

### Summary of the Invention

### Technical Problem

An object of the present invention is to appropriately discharge a waste tape from a tape feeder in a state in which a radial component is separated from a taped component by cutting leads.

### Solution to Problem

In order to solve the above problem, the present specification discloses a tape feeder configured to supply lead components removed from a carrier tape by cutting leads of a taped component, and discharge a waste tape outside of the tape feeder, the taped component being composed of the lead components, each having the leads, and the carrier tape holding the leads of the lead components, the waste tape being composed of remaining leads, which remain on the carrier tape after the leads are cut, and the carrier tape holding the remaining leads in a protruded state; wherein, the tape feeder further comprises: a path, inside the tape feeder, which is used for linearly feeding the taped component before cutting the leads and linearly feeding the waste tape after cutting the leads in a first direction, and then reversing to a second direction opposite to the first direction and linearly feeding in the second direction; a discharge port configured to discharge the waste tape, being fed from the downstream end of the path, downwardly from the tape feeder; and a pushing section, being provided between the downstream end of the path and the discharge port, configured to push a portion of the carrier tape of the waste tape fed from the downstream end of the path in a direction intersecting the path characterized in that 2. a slitshaped opening is formed in a wall surface of a side wall of the tape feeder so as to extend in the second direction of the waste tape, the wall surface being one among a pair of wall surfaces defining the path configured to feed the waste tape in the second direction; and multiple feeding holes of the carrier tape of the waste tape are exposed through the opening.

### Advantageous Effect of the invention

According to the present disclosure, a portion of the waste tape of the carrier tape is pushed by the pushing section in a direction intersecting the path. This makes it possible to appropriately discharge the waste tape from the tape feeder.

### Brief Description of Drawings

[Fig. 1] A perspective view showing an electronic component mounting device.
[Fig. 2] A perspective view of a tape feeder.
[Fig. 3] An enlarged perspective view of the tape feeder.
[Fig. 4] A perspective view showing a feed device and a cutting device.
[Fig. 5] A perspective view showing the feed device and the cutting device.
[Fig. 6] A perspective view showing the feed device.
[Fig. 7] A cross-sectional view of the tape feeder.
[Fig. 8] A perspective view showing a guide mechanism.
[Fig. 9] A perspective view showing the cutting device.
[Fig. 10] A perspective view showing a discharging mechanism.
[Fig. 11] A perspective view showing the discharging mechanism.
[Fig. 12] A perspective view showing a guide surface.
[Fig. 13] A perspective view showing the discharging mechanism.
[Fig. 14] A plan view showing a tape tilting member and a restricting member.
[Fig. 15] A cross-sectional view showing a waste tape that has entered between a tape inclining member and a restricting member.
[Fig. 16] A view showing the waste tape that has entered between the tape inclining member and the restricting member as viewed from above.
[Fig. 17] A cross-sectional view of the tape feeder.

### Description of Embodiment

Hereinafter, an embodiment of the present invention will be described in detail with reference to the drawings.

### (A) Composition of electronic component mounting device

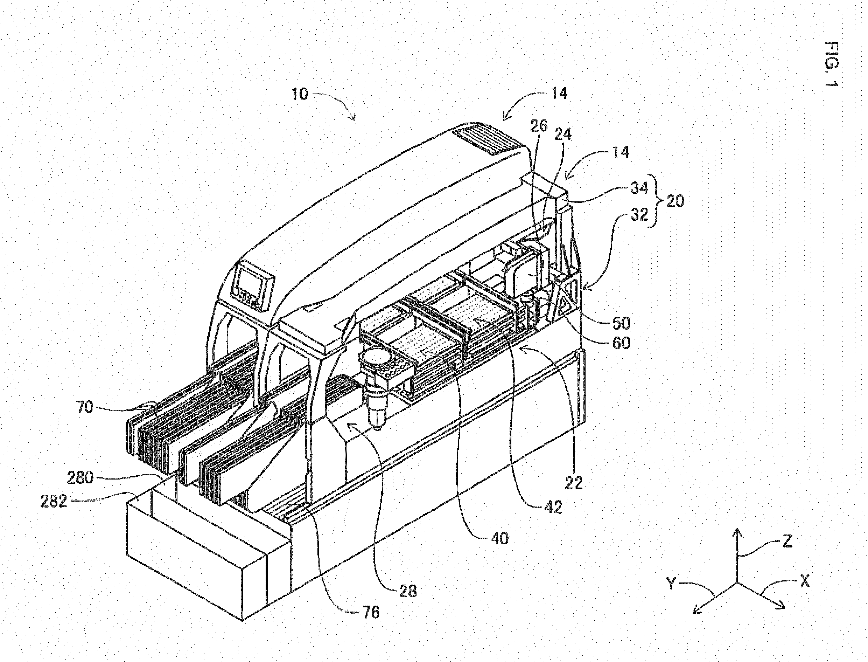

Fig. 1 shows electronic component mounting device 10. Electronic component mounting device 10 is composed of two electronic component mounting machines (hereinafter, sometimes abbreviated as "mounting machines") 14. Each mounting machine 14 mainly includes mounting machine main body 20, conveyance device 22, moving device 24, mounting head 26, and supply device 28.

Mounting machine main body 20 is composed of frame section 32 and beam section 34 overlaid on frame section 32. Conveyance device 22 comprises two conveyor devices 40, 42. Each of the two conveyor devices 40, 42 conveys a circuit board supported by each conveyor device 40, 42. In the following description, the conveyance direction of the circuit board is referred to as the X-direction, the horizontal direction perpendicular to the X-direction is referred to as the Y-direction, and the vertical direction is referred to as the Z-direction.

Moving device 24 is an XY-robot type moving device and moves slider 50 to any position on the XY plane. When mounting head 26 is attached to slider 50, mounting head 26 is moved to any position above frame section 32. Mounting head 26 has suction nozzle 60 provided on the lower-end face thereof. Suction nozzle 60 picks up and holds an electronic component by negative pressure and separates the held electronic component by positive pressure.

Mounting head 26 mounts the electronic component to the circuit board. Suction nozzle 60 is provided on the lower-end face of mounting head 26. Suction nozzle 60 communicates with a positive/negative pressure supply device (not shown) via a negative pressure air and a positive pressure air passage. As a result, suction nozzle 60 picks up and holds an electronic component by negative pressure and separates the held electronic component by positive pressure. Mounting head 26 has a nozzle lifting device (not shown) for lifting and lowering suction nozzle 60 and changes the up-down position of the electronic component to be held.

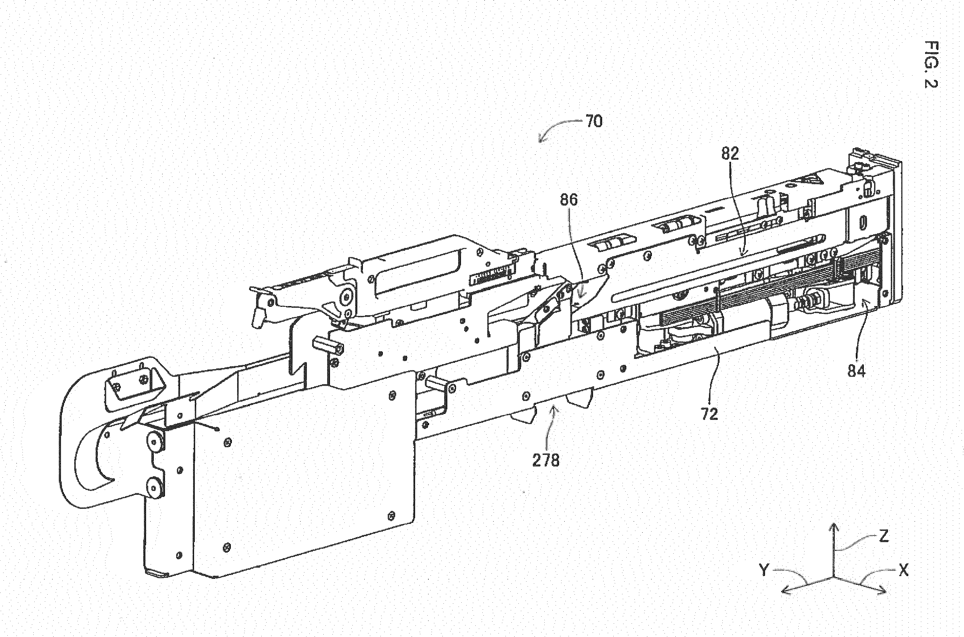

Supply device 28 is a device for feeding components with tape feeder 70. As shown in Fig. 2, tape feeder 70 includes feeder main body 72 and is detachably mounted via feeder main body 72 on mounting table 76 (see Fig. 1) provided at the end of frame section 32. Tape feeder 70 is a device for removing a radial lead component (hereinafter, abbreviated as "radial component") from a taped component and supplying the removed radial component.

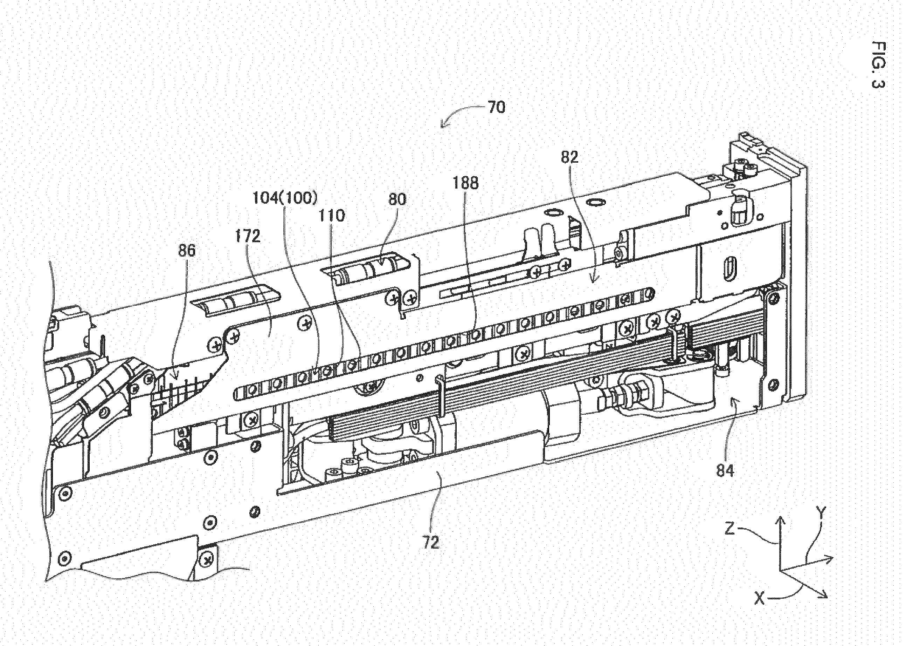

As shown in Fig. 3, tape feeder 70 includes feed device 80, guide mechanism 82, cutting device 84, and discharging mechanism 86; and feed device 80, guide mechanism 82, cutting device 84, and discharging mechanism 86 are disposed inside feeder main body 72, which is a housing for tape feeder 70. In the description of tape feeder 70, the side on which cutting device 84 is disposed is sometimes referred to as the front, and the side opposite to the front is sometimes referred to as the rear.

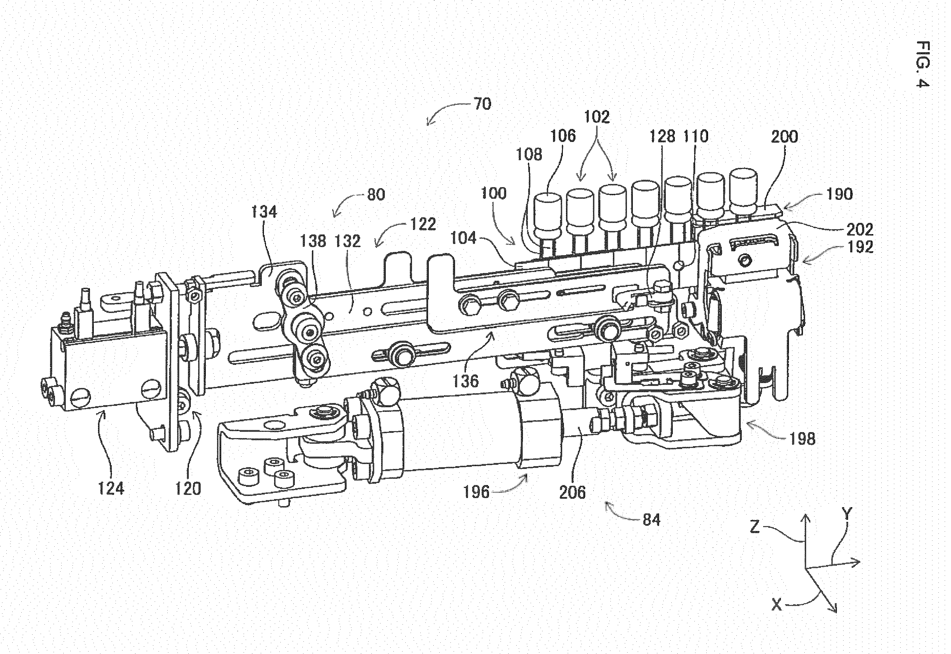

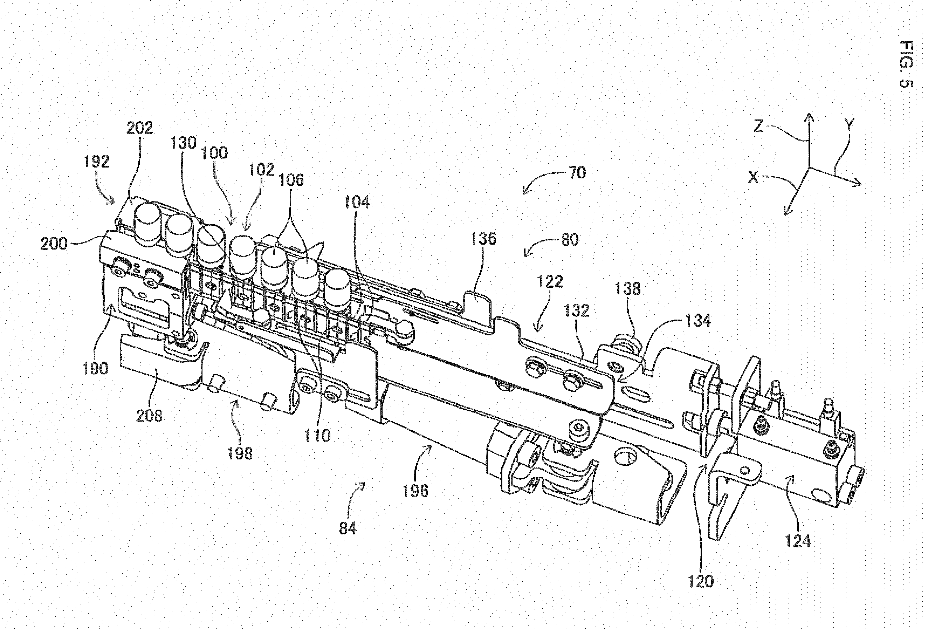

As shown in Figs. 4 and 5, taped component 100 is composed of multiple radial components 102 and carrier tape 104. Each radial component 102 includes a generally cylindrical main body 106 and two leads 108 extending out in the same direction from the bottom face of main body 106. The two leads 108 of each radial component 102 are taped to carrier tape 104 at the lower end of the leads. Carrier tape 104 has multiple feeding holes 110 spaced apart from each other at an equal pitch. Multiple radial components 102 are taped to carrier tape 104 at the same pitch as the pitch of feeding holes 110.

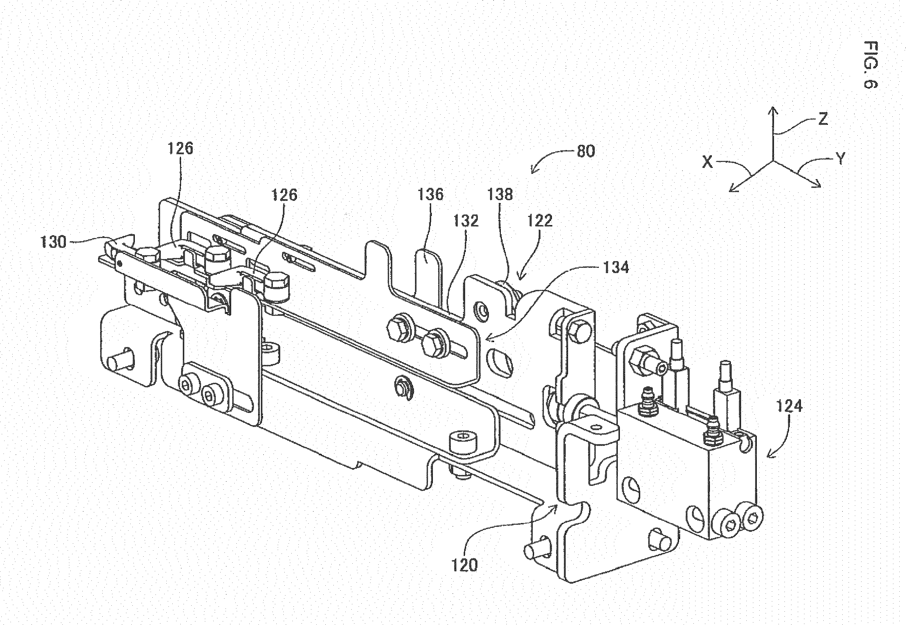

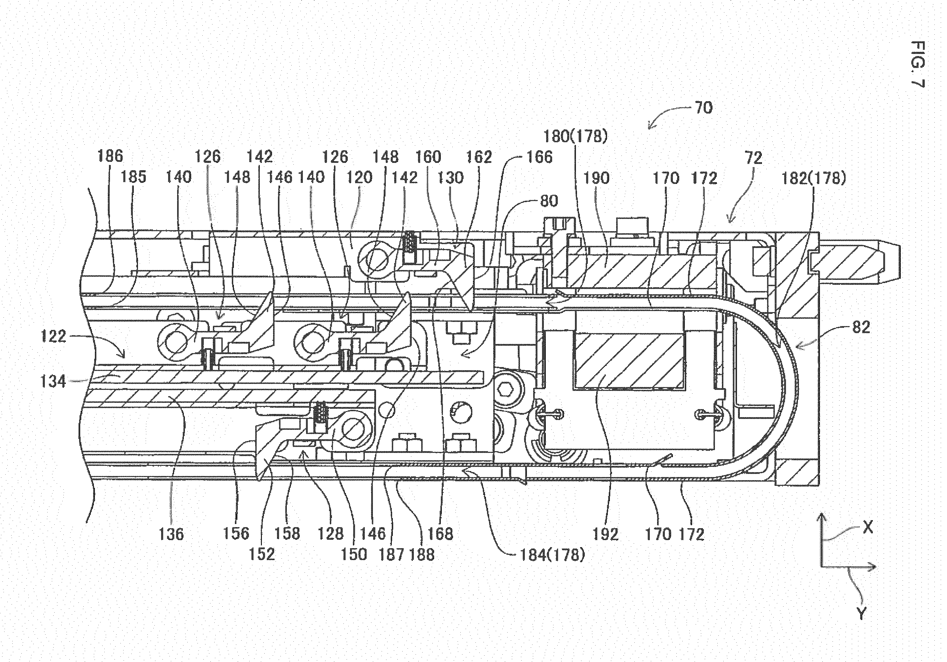

Feed device 80 is disposed at the front of tape feeder 70 and includes base bracket 120, slide mechanism 122, air cylinder 124, a pair of first feed claw members 126, second feed claw member 128, and return prevention claw member 130, as shown in Figs. 4 to 7. It should be noted that Figs. 4 and 5 illustrate not only feed device 80 but also cutting device 84, and Fig. 7 illustrates not only feed device 80 but also guide mechanism 82.

Slide mechanism 122 includes fixed section 132, first slide section 134, second slide section 136, and pivot section 138. Fixed section 132 has a generally rectangular plate shape and is erected from the upper face of base bracket 120 so as to extend in the front-rear direction. First slide section 134 also has a generally rectangular plate shape and is disposed to face one face of fixed section 132 so as to extend in the front-rear direction and is slidably held in place in the front-rear direction by fixed section 132. Second slide section 136 also has a generally rectangular plate shape, and is disposed to face the other face of fixed section 132 so as to extend in the front-rear direction and is slidably held in place in the front-rear direction by fixed section 132.

Pivot section 138 also has a generally rectangular plate shape and is held in place by fixed section 132 in the central portion of tape feeder 70 so as to be pivotable in the front-rear direction. Further, the upper end of pivot section 138 is pivotably coupled to first slide section 134, and the lower end of pivot section 138 is pivotably coupled to second slide section 136.

Air cylinder 124 is fixed to the rear face of base bracket 120 and is connected to the rear end of first slide section 134. As a result, first slide section 134 and second slide section 136 slide in the front-rear direction relative to each other in accordance with the operation of air cylinder 124. That is, when first slide section 134 slides forward, second slide section 136 slides rearward, and when first slide section 134 slides rearward, second slide section 136 slides forward.

Further, as shown in Fig. 7, the pair of first feed claw members 126 are generally L-shaped and are composed of main body section 140 and bent portion 142 bent at about 90 degrees with respect to main body section 140. Each first feed claw member 126 is disposed on first slide section 134 in an orientation in which main body section 140 extends in the front-rear direction and bent portion 142 faces forward. First feed claw member 126 has an orientation in which the tip of bent portion 142 is directed away from first slide section 134. The pair of first feed claw members 126 are arranged side by side in the front-rear direction and the arrangement pitch of the pair of first feeding claw members 126 is twice the pitch between feeding holes 110 in taped component 100.

First feed claw member 126 is held by first slide section 134 at the rear end of main body section 140 so as to be pivotable in the left-right direction. First feed claw member 126 is urged in a direction away from first slide section 134 by a compression coil spring (not shown). The front face of bent portion 142 is perpendicular to main body section 140, but the rear face of bent portion 142 is tapered toward the rear as it approaches main body section 140. For this reason, the front face of bent portion 142 is referred to as perpendicular face 146 while the rear surface of bent portion 142 is referred to as tapered surface 148.

Second feed claw member 128 has substantially the same shape as first feed claw member 126 and is composed of main body section 150 and bent portion 152, similarly to first feed claw member 126. Second feed claw member 128 is disposed on second slide section 136 in an orientation in which main body section 150 extends in the front-rear direction and bent portion 152 faces rearward. Second feed claw member 128 has an orientation in which the tip of bent portion 152 is directed away from second slide section 136. Second feed claw member 128 is held by second slide section 136 at the front end of main body section 150 so as to be pivotable in the left-right direction. Second feed claw member 128 is urged in a direction away from second slide section 136 by a compression coil spring (not shown). In second feed claw member 128, similarly to first feed claw member 126, the rear face of bent portion 152 is referred to as perpendicular face 156, and the front face of bent portion 152 is referred to as tapered face 158.

Return prevention claw member 130 has the same shape as first feed claw member 126 and is composed of main body section 160 and bent portion 162, similarly to first feed claw member 126. Return prevention claw member 130 is disposed on base bracket 120 in an orientation in which main body section 160 extends in the front-rear direction and bent portion 162 faces forward. Return prevention claw member 130 is disposed so as to face, in the X-direction, the first feed claw member 126, disposed toward the front, of the pair of first feed claw members 126, and return prevention claw member 130 has an orientation in which the tip of bent portion 162 faces first feed claw member 126. However, return prevention claw member 130 is disposed slightly forward of first feed claw member 126 and bent portion 162 of return prevention claw member 130 is located forward of bent portion 142 of first feed claw member 126. Return prevention claw member 130 is held by base bracket 120 at the rear end of main body section 160 so as to be pivotable in the left-right direction. Return prevention claw member 130 is urged by a compression coil spring (not shown) in a direction approaching first feed claw member 126.

Further, the tip of bent portion 162 of return prevention claw member 130 and the tip of bent portion 142 of first feed claw member 126 overlap each other in the Y-direction. The distance between the tip of bent portion 162 of return prevention claw member 130 and the tip of bent portion 142 of first feed claw member 126 is a distance corresponding to the pitch between feeding holes 110 of taped component 100. Also in return prevention claw member 130, similarly to first feed claw member 126, the rear face of bent portion 162 is referred to as perpendicular face 166, and the front face of bent portion 162 is referred to as tapered face 168.

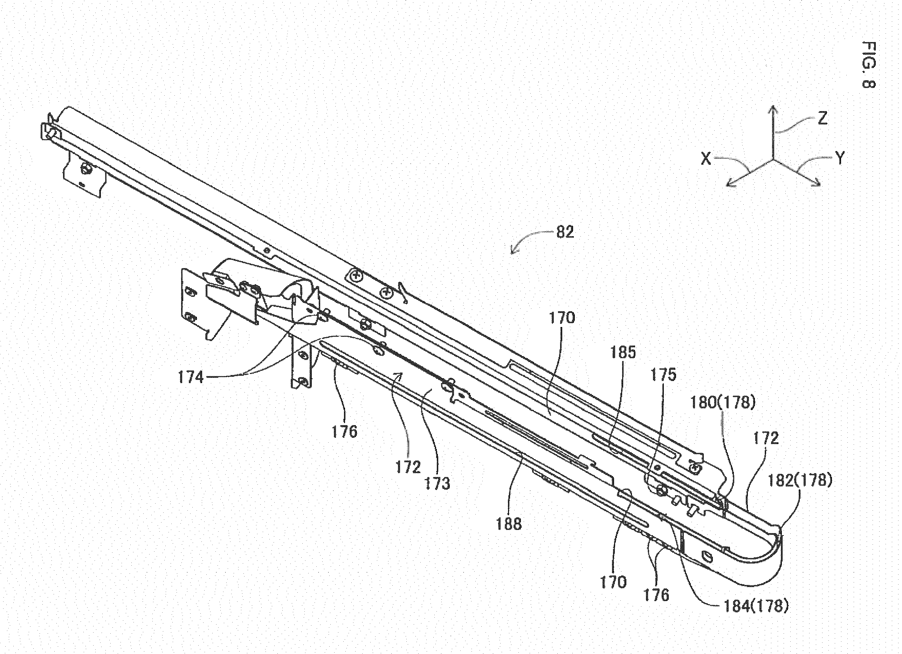

As shown in Figs. 7 and 8, guide mechanism 82 includes inner wall section 170 and outer wall section 172. Inner wall section 170 has a shape in which a strip-shaped plate member is bent into a general U-shape, and outer wall section 172 also has a shape in which a strip-shaped plate member is bent into a general U-shape. Inner wall section 170 and outer wall section 172 are bolted to each other in a manner in which inner wall section 170 and outer wall section 172 face each other with a predetermined dimension of about 2mm therebetween.

More specifically, inner wall section 170 and outer wall section 172 have a U-shape that extends linearly toward the front in the Y-direction, then reverses in the direction opposite to the front, that is, reverses rearward, and extends linearly toward the rear. Inner wall section 170 and outer wall section 172 face each other with a predetermined dimension therebetween so that inner wall section 170 is positioned inside outer wall section 172.

Further, as shown in Fig. 8, step section 173 that bends toward inner wall section 170 is formed at the upper edge of a portion extending rearward from outer wall section 172. In step section 173, inner wall section 170 and outer wall section 172 are fastened by multiple bolts 174. As a result, inner wall section 170 and outer wall section 172 are integrally fixed. As shown in Fig. 7, inner wall section 170 and outer wall section 172 are disposed inside feeder main body 72 so that the parts of inner wall section 170 and outer wall section 172 which are bent into a U-shape face the front. Incidentally, inner wall section 170 is fixed to feeder main body 72 by multiple bolts 175 (see Fig. 8), and outer wall section 172 is fixed to feeder main body 72 by multiple bolts 176 (see Fig. 8).

As a result, path 178 having a predetermined width is defined by inner wall section 170 and outer wall section 172 in feeder main body 72. Path 178 includes first straight section 180 linearly extending toward the front, reversing section 182 reversing from frontward direction to the rearward direction, and second straight section 184 linearly extending toward the rear.

In addition, inner wall section 170, which defines first straight section 180 of path 178, has slit 185 extending in the Y-direction, and outer wall section 172, which defines first straight section 180 of path 178, has slit 186 facing slit 185. Slits 185, 186 are formed at the front of first straight section 180. In addition, inner wall section 170, which defines second straight section 184 of path 178, has slit 187 extending in the Y-direction, and outer wall section 172, which defines second straight section 184 of path 178, has slit 188 facing slit 187. Slits 187, 188 extend through the entire longitudinal length of second straight section 184.

Inside feeder main body 72, slide mechanism 122 of feed device 80, the pair of first feed claw members 126, and second feed claw member 128 are disposed inside inner wall section 170. On the other hand, return prevention claw member 130 of feed device 80 is disposed outside outer wall section 172. The tips of bent portions 142 of the pair of first feed claw members 126 and the tip of bent portion 162 of return prevention claw member 130 are inserted into slit 185 of inner wall section 170 and slit 186 of outer wall section 172.

The tip of bent portion 152 of second feed claw member 128 is inserted into slit 187 of inner wall section 170 and slit 188 of outer wall section 172. The tip of bent portion 152 of second feed claw member 128 slightly protrudes to the outside of outer wall section 172 through slits 187, 188. That is, slit 187 is a slit for inserting the tip of bent portion 152 of second feed claw member 128 between inner wall section 170 and outer wall section 172. Slit 188 is a slit for preventing contact between the tip of bent portion 152 of second feed claw member 128 and outer wall section 172.

In such a structure, in guide mechanism 82, carrier tape 104 of taped component 100 is inserted between inner wall section 170 and outer wall section 172 in a state in which the width direction of carrier tape 104 extends in the up-down direction, that is, in an upright state. The state in which carrier tape 104 is upright is a state in which carrier tape 104 and the upper face of tape feeder 70 generally intersect at a right angle, and leads 108 taped to carrier tape 104 extend in the up-down direction.

Each radial component 102 held by carrier tape 104 extends upward from between inner wall section 170 and outer wall section 172. In carrier tape 104 inserted between inner wall section 170 and outer wall section 172, the tips of bent portions 142 of the pair of first feed claw members 126 engage with feeding holes 110 through slit 185 of inner wall section 170 of guide mechanism 82. Further, the tip of bent portion 162 of return prevention claw member 130 engages with feeding hole 110 through slit 186 of outer wall section 172 of guide mechanism 82. Further, the tip of bent portion 152 of second feed claw member 128 engages with feeding hole 110 through slit 187 of inner wall section 170 of guide mechanism 82.

As shown in Figs. 4 and 5, cutting device 84 is disposed below feed device 80. As shown in Figs. 4, 5, 9, and 10, cutting device 84 includes fixed member 190, pivot member 192, roller 194, air cylinder 196, and conversion mechanism 198. As shown in Fig. 7, fixed member 190 and pivot member 192 are arranged side by side in the X-direction in front of first feed claw members 126 and return prevention claw member 130 of feed device 80, with inner wall section 170 and outer wall section 172 of guide mechanism 82 interposed therebetween.

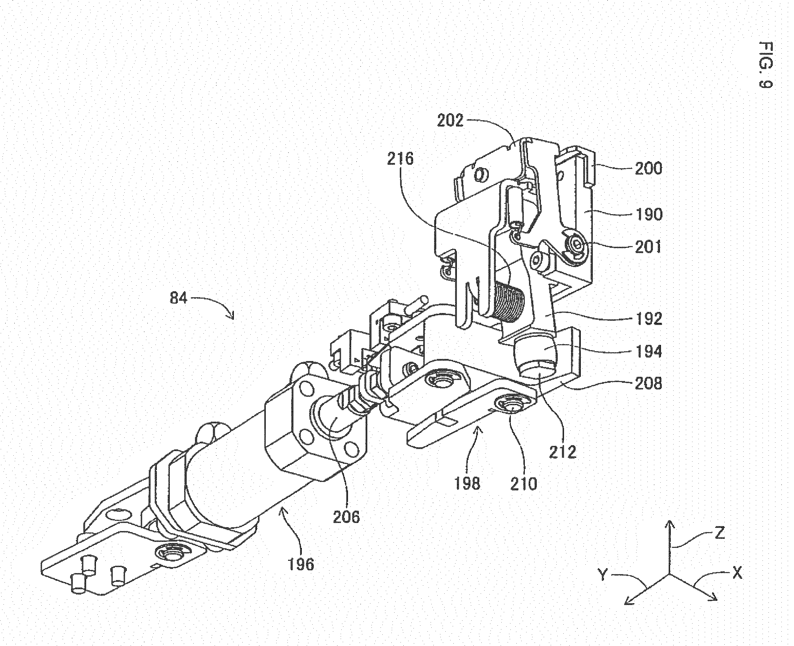

Fixed member 190 is fixed in an up-down extended orientation in a state facing outer wall section 172 of guide mechanism 82 that defines the front end of first straight section 180 of path 178. The upper end of fixed member 190 extends upward from the upper edge of outer wall section 172, and clamping plate 200 is fixed to the upper end of fixed member 190. In addition, pivot member 192 is disposed in an orientation extending in the up-down direction and faces fixed member 190, with inner wall section 170 and outer wall section 172 being sandwiched between pivot member 192 and fixed member 190, and pivot member 192 can pivot about shaft (see Fig. 9) 201, extending in the Y-direction, in a central portion of the up-down direction. The upper end of pivot member 192 extends upward from the upper end of inner wall section 170, and clamping plate 202 is fixed to the upper end of pivot member 192.

Pivot member 192 pivots such that the upper end of pivot member 192 approaches fixed member 190, causing leads 108 of radial component 102 of taped component 100, which are inserted between inner wall section 170 and outer wall section 172, to be clamped by clamping plate 200 of fixed member 190 and clamping plate 202 of pivot member 192. A pivoting cutter (not shown) is disposed below clamping plate 202 of pivot member 192 and a fixed cutter (not shown) is disposed on fixed member 190 so as to face the pivoting cutter.

As shown in Fig. 4, air cylinder 196 is disposed below feed device 80 so as to extend in the front-rear direction with rod 206 facing forward. Conversion mechanism 198 is disposed in front of air cylinder 196, and rod 206 of air cylinder 196 is connected to conversion mechanism 198. As shown in Fig. 9, conversion mechanism 198 includes pushing member 208 having a general L-shape, and pushing member 208, in the central portion, is supported by shaft 210 extending in the up-down direction so as to pivot. By way of rod 206 of air cylinder 196 moving in the front-rear direction, conversion mechanism 198 pivots pushing member 208.

Roller 194 is rotatably held on the lower end face of pivot member 192 by shaft 212 extending in the up-down direction. Roller 194 faces pushing member 208 of conversion mechanism 198. Pivot member 192 is biased by compression coil spring 216 in a direction in which roller 194 approaches pushing member 208. As a result, roller 194 comes in close contact with pushing member 208, and by pushing member 208 pivoting with the operation of air cylinder 196, pivot member 192 pivots. More specifically, rod 206 of air cylinder 196 moves rearward so that pushing member 208 pivots in a direction approaching roller 194. As a result, pivot member 192 pivots in a direction in which the upper end of pivot member 192 approaches fixed member 190 against the elastic force of compression coil spring 216. On the other hand, when rod 206 of air cylinder 196 moves forward, pushing member 208 pivots away from roller 194. As a result, by the elastic force of compression coil spring 216, pivot member 192 pivots so that the upper end of pivot member 192 separates from fixed member 190.

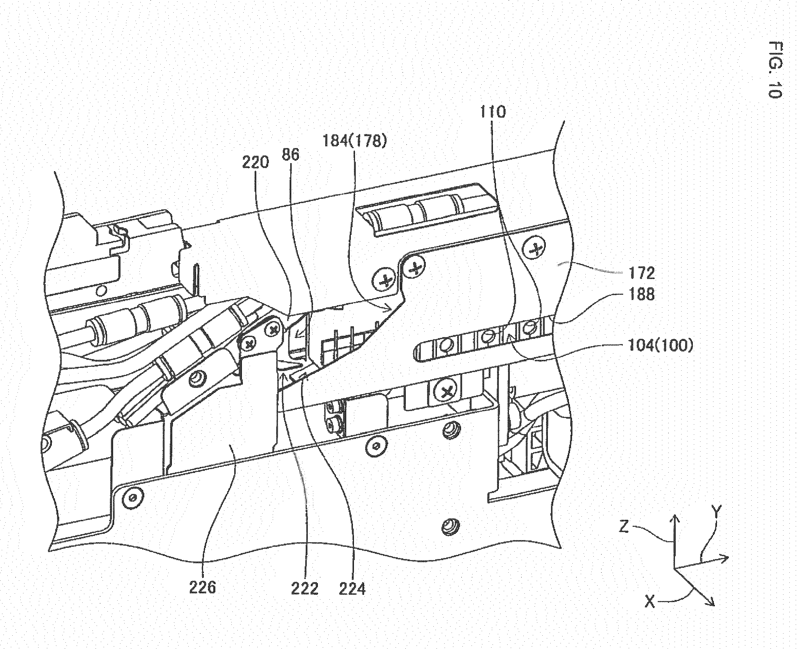

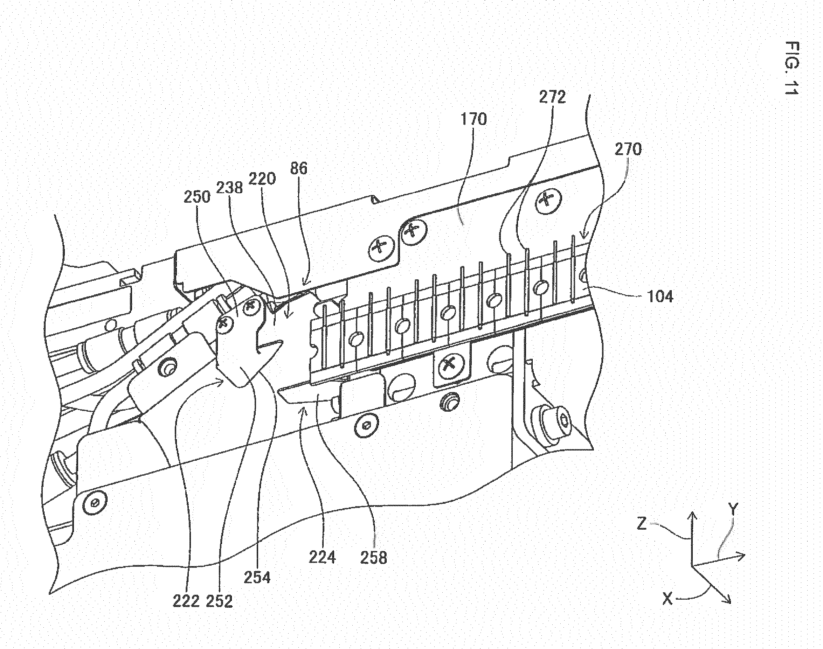

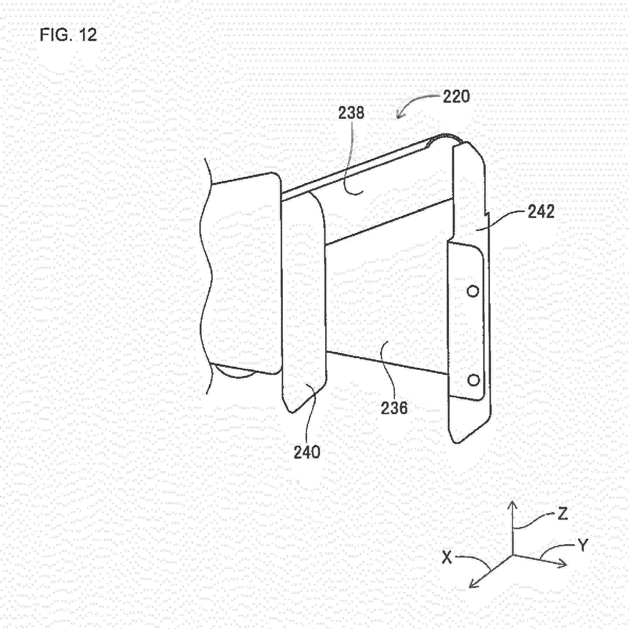

As shown in Figs. 10 and 11, discharging mechanism 86 includes guide surface 220, tape inclining member 222, restricting member 224, and cover plate 226. Fig. 11 is a view in which outer wall section 172 and cover plate 226 are removed. Guide surface 220 is disposed behind inner wall section 170 and outer wall section 172 that define second straight section 184 of path 178, and guide surface 220 is configured by flat surface 236 and curved surface 238, as shown in Fig. 12. Flat surface 236 is erected so as to extend in the Y-direction, and the upper end of flat surface 236 descends toward the rear in the form of an oblique line. Curved surface 238 is provided at the upper end of flat surface 236 and curves at about 90 degrees so as to separate from flat surface 236 in the X-direction as curved surface 238 extends upward from the upper end of flat surface 236.

That is, curved surface 238 curves downward so that the cross-sectional shape thereof is an arc with a center angle of about 90 degrees and the lower end of curved surface 238 is continuous with the upper end of flat surface 236. Since the upper end of flat surface 236 forms an oblique line that descends toward the rear, as described above, curved surface 238 is tilted to face obliquely forward, that is, curved surface faces the rear end of inner wall section 170 and outer wall section 172. Guide surface 220 is supported by first support plate 240 at the rear end and is supported by second support plate 242 at the front end.

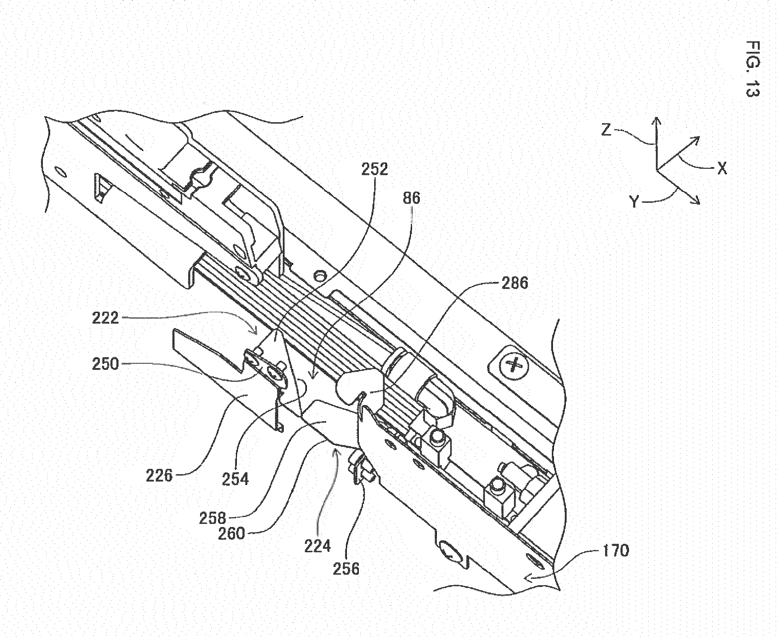

In addition, as shown in Fig. 13, tape inclining member 222 has a shape in which a plate-like member is bent in an L-shape and is composed of bracket section 250 extending upward and protruding portion 252 bent at 90 degrees with respect to bracket section 250. As shown in Fig. 11, tape inclining member 222 is fixed to the upper end of curved surface 238 of guide surface 220 in bracket section 250 and protruding portion 252 protrudes toward curved surface 238. Inclined portion 254 is formed on the edge of protruding portion 252 on the side protruding toward curved surface 238, and inclined portion 254 forms an oblique line closer to curved surface 238 toward the rear. That is, protruding portion 252 has a shape in which the amount of protrusion gradually increases toward the rear of inclined portion 254. Incidentally, the inclination angle of inclined portion 254 with respect to the Y-direction is about 40 degrees.

As shown in Fig. 13, restricting member 224 has a shape in which a plate-like member is bent in an L-shape and is composed of bracket section 256 extending downward and bent portion 258 bent at 90 degrees with respect to bracket section 256. Restricting member 224 is fixed to the lower end of second support plate 242 of guide surface 220 in bracket section 256 and bent portion 258 extends toward the lower side of protruding portion 252 of tape inclining member 222.

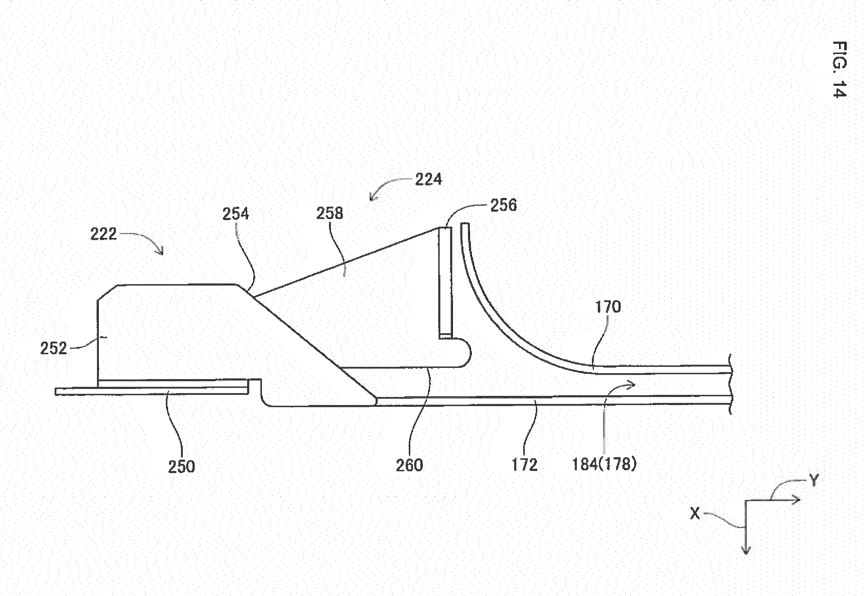

In addition, as shown in Fig. 14, tape inclining member 222 and restricting member 224 are arranged so that the central part of inclined portion 254 of tape inclining member 222 and the rear portion of bent portion 258 of restricting member 224 overlap in the up-down direction. Side edge 260 of bent portion 258 partially overlapping with inclined portion 254 in the up-down direction has a straight shape extending in the Y-direction, and the center portion of inclined portion 254 overlaps with side edge 260 of bent portion 258 in the up-down direction, but the front end of inclined portion 254 does not overlap with side edge 260 of bent portion 258 in the up-down direction. That is, there is a gap between the front end of inclined portion 254 and side edge 260 of bent portion 258 in the up-down direction. The front end of inclined portion 254, side edge 260 of bent portion 258, and second straight line section 184 of path 178 defined by inner wall section 170 and outer wall section 172 coincide in the Y-direction.

The distance in the up-down direction between protruding portion 252 of tape inclining member 222 and bent portion 258 of restricting member 224 is shorter than the width of carrier tape 104 inserted in path 178. The bottom face of path 178 is located slightly below bent portion 258 of restricting member 224.

As shown in Figs. 10 and 13, cover plate 226 has a general plate shape and is disposed so as to face guide surface 220. tape inclining member 222 is disposed between guide surface 220 and cover plate 226. That is, cover plate 226 is disposed so as to cover guide surface 220 and tape inclining member 222.

### (B) Operation of the tape feeder

With the above structure, in tape feeder 70, taped component 100 is fed by the operation of air cylinder 124 of feeding device 80, and leads 108 are cut by the operation of air cylinder 196 of cutting device 84, thereby separating radial components 102 from carrier tape 104. As a result, radial components 102 are supplied. Then, waste tape 270 in a state in which radial components 102 are removed from taped component 100 by cutting of leads 108, that is, in a separated state (see Fig. 11), is discharged to the outside of tape feeder 70. As shown in Fig. 11, waste tape 270 is composed of remaining leads 272, remaining on carrier tape 104 after leads 108 have been cut, and carrier tape 104 holding remaining leads 272 in a state in which remaining leads 272 protrude from the upper edge. Hereinafter, a specific operation of tape feeder 70 will be described.

In electronic component mounting device 10, as shown in Fig. 1, dust box 280 is disposed behind mounting table 76, and storage box 282 is disposed behind dust box 280. In storage box 282, taped component 100 is stored in a folded state. The end of taped component 100 is then pulled out from storage box 282, and taped component 100 is set in tape feeder 70 mounted on mounting table 76. At this time, taped component 100 is inserted into path 178 of guide mechanism 82, and first feed claw members 126 or the like engage with feeding holes 110 of taped component 100.

Then, in feed device 80, by the operation of air cylinder 124, first slide section 134 of slide mechanism 122 slides forward so that the pair of first feed claw members 126 also slides forward. At this time, the tips of bent portions 142 of the pair of first feeding claw members 126 engage with feeding holes 110 of taped component 100 inserted in guide mechanism 82 and taped component 100 is pushed forward by perpendicular faces 146 of bent portions 142. Since each perpendicular face 146 is perpendicular to taped component 100, the force pushing forward by each perpendicular face 146 is transmitted to taped component 100 and taped component 100 is fed forward. That is, taped component 100 is linearly fed forward along first straight section 180 of path 178. The feed amount of taped component 100, that is, the slide amount of first slide section 134 is an amount corresponding to the arrangement pitch of radial components 102 in taped component 100.

In slide mechanism 122, as described above, when first slide section 134 slides forward, second slide section 136 slides rearward. Therefore, second feed claw member 128 slides rearward together with second slide section 136. At this time, the tip of bent portion 152 of second feed claw member 128 engages with feeding hole 110 of taped component 100 inserted in guide mechanism 82, and taped component 100 is pushed rearward by perpendicular face 156 of bent portion 152. Since perpendicular face 156 is perpendicular to taped component 100, the force pushing rearward by perpendicular face 156 is transmitted to taped component 100 and taped component 100 is fed rearward. That is, taped component 100 is linearly fed rearward along second straight section 184 of path 178.

In this manner, in guide mechanism 82, taped component 100 is inserted between inner wall section 170 and outer wall section 172, and is set upright while being bent in a U-shape. Taped component 100 is then fed forward by the pair of first feeding claw members 126 upstream from the U-shaped bent section. At the same time, taped component 100 is fed rearward by second feed claw member 128 downstream from the U-shaped bent section. As described above, taped component 100 is fed both on the upstream side and the downstream side of the section bent into a U-shape so that taped component 100 can be appropriately fed without delay within guide mechanism 82.

Although return prevention claw member 130 is also engaged with feeding hole 110 of taped component 100 inserted into guide mechanism 82, return prevention claw member 130 is disengaged when taped component 100 is fed. In particular, as taped component 100 is dispensed, bent portion 162 of return prevention claw member 130 engaged with feeding hole 110 is pushed forward by the edge defining feeding hole 110 at tapered face 168. Tapered face 168 is not perpendicular to taped component 100 and is inclined rearward as it approaches the proximal end of bent portion 162, that is, main body section 160. Therefore, the force pushing tapered surface 168 forward is distributed in a direction in which bent portion 162 separates from taped component 100, and return prevention claw member 130 pivots in a direction in which return preventing claw member 130 separates from taped component 100. As a result, when taped component 100 is fed, return prevention claw member 130 disengages from taped component 100.

After the feeding of taped component 100 is completed, first slide section 134 of slide mechanism 122 slides rearward and second slide section 136 slides forward by the operation of air cylinder 124. Therefore, the pair of first feeding claw members 126 slides rearward and second feeding claw member 128 slides forward. At this time, return prevention claw member 130 prevents taped component 100 from returning in the direction opposite to the feeding direction, and first feed claw members 126 and second feeding claw member 128 disengage from feeding holes 110.

More specifically, when first feed claw member 126 slides rearward, bent portion 142 of first feed claw member 126 engaged with feeding hole 110 pushes the edge defining the feeding hole 110 rearward on tapered surface 148. Bent portion 152 of second feed claw member 128 engaged with feeding hole 110 pushes the edge defining feeding hole 110 forward on tapered face 158. For this reason, a force for returning taped component 100 in a direction opposite to the feeding direction is transmitted to taped component 100.

At this time, bent portion 162 of return prevention claw member 130 engages with feeding hole 110, and perpendicular face 166 of bent portion 162 is pushed rearward by the edge defining feeding hole 110. However, since perpendicular face 166 is perpendicular to taped component 100, the force pushing perpendicular face 166 is not dispersed in the left-right direction and return prevention claw member 130 does not pivot. Therefore, the engagement of return prevention claw member 130 with feeding hole 110 is maintained, and the return of taped component 100 in the opposite direction to the feeding direction is prevented.

Tapered surface 148 of bent portion 142 of each first feed claw member 126 is inclined toward the rear as it approaches main body section 140. Therefore, when first feed claw member 126 slides rearward, a reactionary force by which tapered surface 148 pushes the edge defining feeding hole 110 is generated in a direction in which bent portion 142 separates from taped component 100. As a result, first feed claw members 126 pivot away from taped component 100 and first feed claw members 126 disengage from taped component 100. First feed claw members 126 slide rearward and return to the position before the feeding of taped component 100, and then engage with feeding holes 110 of taped component 100 which has been fed.

In addition, tapered surface 158 of bent portion 152 of second feed claw member 128 is inclined toward the front as it approaches main body section 150. Therefore, when second feed claw member 128 slides forward, a reactionary force by which tapered surface 158 pushes the edge defining feeding hole 110 is generated in a direction in which bent portion 152 separates from taped component 100. As a result, second feed claw member 128 pivots away from taped component 100, and second feed claw member 128 disengages from taped component 100. Second feed claw member 128 slides forward and returns to the position before the feeding of taped component 100, and then engages with feeding hole 110 of taped component 100 which has been fed.

As a result, the return of taped component 100 in the opposite direction to the feeding direction is prevented, and first feeding claw members 126 and second feed claw member 128 are returned to the position before feeding of taped component 100. Air cylinder 124 is then operated again, and by first slide section 134 of slide mechanism 122 sliding forward, taped component 100 is fed. As described above, by the operation of air cylinder 124, each time first slide section 134 sequentially slides in the front-rear direction, taped component 100 is fed by an amount corresponding to the arrangement pitch of radial components 102.

When the feeding of taped component 100 is completed, air cylinder 196 is operated in cutting device 84, and radial components 102 are separated from carrier tape 104. More specifically, when first slide section 134 slides forward and second slide section 136 slides rearward by the operation of air cylinder 124 in feed device 80, rod 206 of air cylinder 196 moves forward in cutting device 84. Therefore, when taped component 100 is being fed, pivot member 192 pivots in a direction in which the upper end separates from fixed member 190 by the elastic force of compression coil spring 216. At this time, leads 108 of radial component 102 held by carrier tape 104 enter between the upper end of fixed member 190 and the upper end of pivot member 192 in conjunction with the feeding of taped component 100.

Rod 206 is then moved rearward by the operation of air cylinder 196 when the feeding of taped component 100 is completed. As a result, pivot member 192 pivots in a direction in which the upper end approaches fixed member 190 against the elastic force of compression coil spring 216. At this time, leads 108 inserted between the upper end of fixed member 190 and the upper end of pivot member 192 are clamped by clamping plate 200 of fixed member 190 and clamping plate 202 of pivot member 192.

Leads 108 clamped by clamping plate 200 of fixed member 190 and clamping plate 202 of pivot member 192 is then cut by the pivoting cutter of pivot member 192 and the fixed cutter of fixed member 190. As a result, radial components 102 are separated from carrier tape 104 and supplied in a state in which radial components 102 are clamped at leads 108 by clamping plates 200, 202.

Further, by cutting leads 108, radial component 102 separates from carrier tape 104, whereby taped component 100 becomes waste tape 270. The feeding direction of waste tape 270 is then reversed from the forward direction to the rearward direction in reversing section 182 of path 178, and waste tape 270 is fed rearward in second straight section 184 of path 178.

As described above, waste tape 270 is fed rearward in second straight section 184 of path 178 and thus extends rearward from the rear end of second straight section 184. Waste tape 270 extending rearward from the rear end of second straight section 184 enters between protruding portion 252 of tape inclining member 222 and bent portion 258 of restricting member 224. As described above, the distance between protruding portion 252 of tape inclining member 222 and bent portion 258 of restricting member 224 in the up-down direction is shorter than the width of carrier tape 104. The bottom face of path 178 is located slightly below bent portion 258 of restricting member 224.

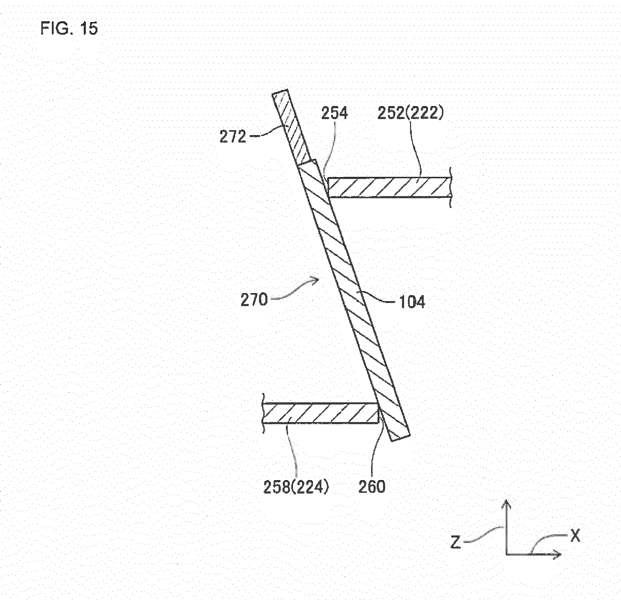

Therefore, as shown in Fig. 15, waste tape 270, which has entered between protruding portion 252 of tape inclining member 222 and bent portion 258 of restricting member 224, comes in contact with side edge 260 of bent portion 258 of restricting member 224 at the lower end of carrier tape 104. Waste tape 270 contacts inclined portion 254 of protruding portion 252 of tape inclining member 222 at the upper edge of carrier tape 104. At this time, waste tape 270 is guided in the protruding direction of protruding portion 252 by protruding portion 252 at the upper end but is restricted in the guiding direction by bent portion 258 at the lower end. As a result, waste tape 270, between tape inclining member 222 and restricting member 224, is tilted from a standing state to an inclined state. That is, when the upper end of waste tape 270 is pushed in a direction intersecting with the feeding direction of waste tape 270, waste tape 270 is tilted with respect to the up-down direction.

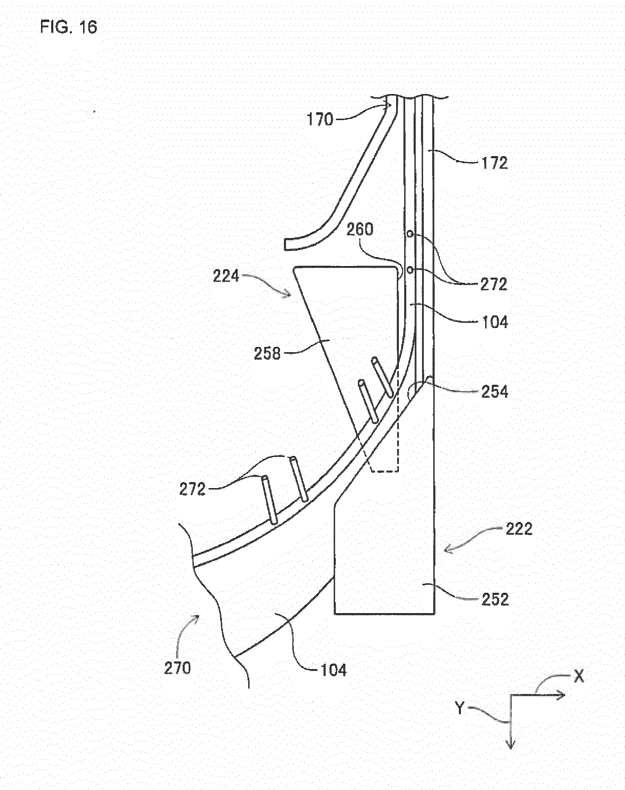

Further, as described above, the protruding amount of protruding portion 252 gradually increases toward the rear, that is, toward the feeding direction of waste tape 270. Therefore, as shown in Fig. 16, as waste tape 270 is fed rearward, the amount by which the upper end of waste tape 270 is guided toward the protruding direction of protruding portion 252 increases. On the other hand, side edge 260 of restricting member 224 extends linearly in the Y-direction. For this reason, the lower end of waste tape 270 is fed substantially in the Y-direction. As a result, the angle of inclination of waste tape 270 with respect to the up-down direction increases as waste tape 270 is fed rearward. That is, the orientation of waste tape 270 changes from an orientation in which the width direction extends in the up-down direction to an orientation in which the width direction extends in the left-right direction. As described above, when the orientation of waste tape 270 changes to an orientation in which the width direction extends in the left-right direction and waste tape 270 is pulled out from between tape inclining member 222 and restricting member 224, the end of waste tape 270 in the feeding direction faces downward due to its own weight.

Waste tape 270 is then fed further rearward by feed device 80 and thus waste tape 270 pulled out from between tape inclining member 222 and restricting member 224 comes into contact with curved surface 238 of guide surface 220. At this time, since the end of waste tape 270 in the feeding direction faces downward due its own weight, waste tape 270 is smoothly guided toward flat surface 236 along curved surface 238. That is, waste tape 270 is guided downward along guide surface 220 continuously from curved surface 238 to flat surface 236.

Discharge port 278 is formed below discharging mechanism 86 on the lower face of tape feeder 70, and dust box 280 is disposed below discharge port 278. As a result, waste tape 270 guided downward along guide surface 220 is discharged to the lower side of tape feeder 70 via discharge port 278 and is discarded to dust box 280.

### (C) Preventing jamming of waste tape in the path

In this manner, in tape feeder 70, taped component 100 is fed forward in first straight section 180 of path 178, and radial component 102 is removed from taped component 100, thereby supplying radial component 102. Next, the removed waste tape 270 of radial component 102 is reversed rearward in reversing section 182 of path 178 and is fed rearward in second straight section 184. Waste tape 270 extending from the downstream end of second straight section 184 is folded downward in discharging mechanism 86 and is discharged from discharge port 278 formed on the lower face of tape feeder 70.

As a result, waste tape 270 can be discharged directly under tape feeder 70, and multiple tape feeders 70 can be disposed in positions in which the side faces of tape feeders 70 are close to each other. Further, by feeding waste tape 270 rearward in second straight section 184, dust box 280 can be disposed outside mounting machine 14.

However, in tape feeder 70, after remaining waste tape 270 of remaining lead 272 is fed rearward from second straight section 184 of path 178, the feeding direction of waste tape 270 is changed downward by discharging mechanism 86, and waste tape 270 is discharged from the lower face of tape feeder 70. Therefore, when feeding direction of waste tape 270 is changed, a load is applied to waste tape 270, and jamming (i.e., a phenomenon in which waste tape 270 bends due to the load on waste tape 270 and waste tape 270 cannot be fed) may occur.

In particular, since taped component 100 is stored in a folded state in storage box 282, creases are formed in carrier tape 104. When the folding line is formed in a state overlapping with feeding hole 110 of carrier tape 104, the rigidity of carrier tape 104 is lowered, and jamming easily occurs at the folding line portion. Therefore, in tape feeder 70, various measures are taken to suppress the occurrence of jamming in path 178 and the like.

More specifically, when the orientation of waste tape 270 is changed by tape inclining member 222 and restricting member 224, tape inclining member 222 pushes carrier tape 104 of waste tape 270, being fed from path 178, in the extending direction of path 178, that is, in the direction intersecting the feeding direction of waste tape 270. That is, in waste tape 270, tape inclining member 222 pushes not remaining leads 272 protruding from the upper edge of carrier tape 104 but pushes from the upper edge and downward of carrier tape 104.

For example, in the case where remaining lead 272 protruding from the upper edge of carrier tape 104 is pushed by tape inclining member 222 in waste tape 270, remaining lead 272 protruding from the upper edge of carrier tape 104 may get caught by tape inclining member 222. In particular, when the arrangement pitch of radial components 102 in taped component 100 is large, the arrangement pitch of remaining leads 272 becomes large, making it easy for remaining leads 272 to get caught by tape inclining member 222. As described above, if remaining lead 272 is caught by tape inclining member 222, waste tape 270 may not be properly fed and jamming may occur.

In view of this, in tape feeder 70, as shown in Figs. 15 and 16, tape inclining member 222 is disposed so as to come in contact with a portion of waste tape 270 below the upper edge of carrier tape 104. As a result, it is possible to prevent remaining lead 272 from getting caught by tape inclining member 222 and to suppress jams from occurring. Since remaining lead 272 is held on carrier tape 104 of waste tape 270, remaining lead 272 held on carrier tape 104 may come in contact with tape inclining member 222. However, since sliding resistance is reduced by carrier tape 104 at the position where remaining lead 272 is held by carrier tape 104, waste tape 270 and tape inclining member 222 are less likely to get caught.

With the orientation changed from the upright state to the inclined state by tape inclining member 222 and restricting member 224, waste tape 270 contacts guide surface 220 and is fed downward. At this time, remaining leads 272 of waste tape 270 may come into contact with guide surface 220 so that waste tape 270 is fed in a direction toward the side face of tape feeder 70 instead of downward. In this case, waste tape 270 is fed from the inside of discharging mechanism 86, for example, from the lower portion of tape inclining member 222 toward the side face of tape feeder 70, and with waste tape 270 stopping below tape inclining member 222, jamming may occur.

In view of this, in tape feeder 70, as shown in Figs. 10 and 13, cover plate 226 is disposed to cover the lower portion of tape inclining member 222 from the side face of tape feeder 70. Therefore, waste tape 270 fed from the lower portion of tape inclining member 222 toward the side face of tape feeder 70 comes in contact with cover plate 226 and is guided downward by cover plate 226. This makes it possible to suppress the stopping of waste tape 270 under tape inclining member 222, thereby minimizing the occurrence of jamming.

When waste tape 270 is fed from the downstream end of second straight section 184 of path 178 toward discharging mechanism 86, waste tape 270 is pushed away from tape inclining member 222 by tape inclining member 222 of discharging mechanism 86. Therefore, when waste tape 270 is fed from the downstream end of second straight section 184 of path 178, there is a possibility that waste tape 270 will slide into contact with the downstream end of inner wall section 170 that defines second straight section 184. When waste tape 270 slides on the downstream end of inner wall section 170 in this manner, the feeding out of waste tape 270 is hindered by sliding resistance, and jamming may occur.

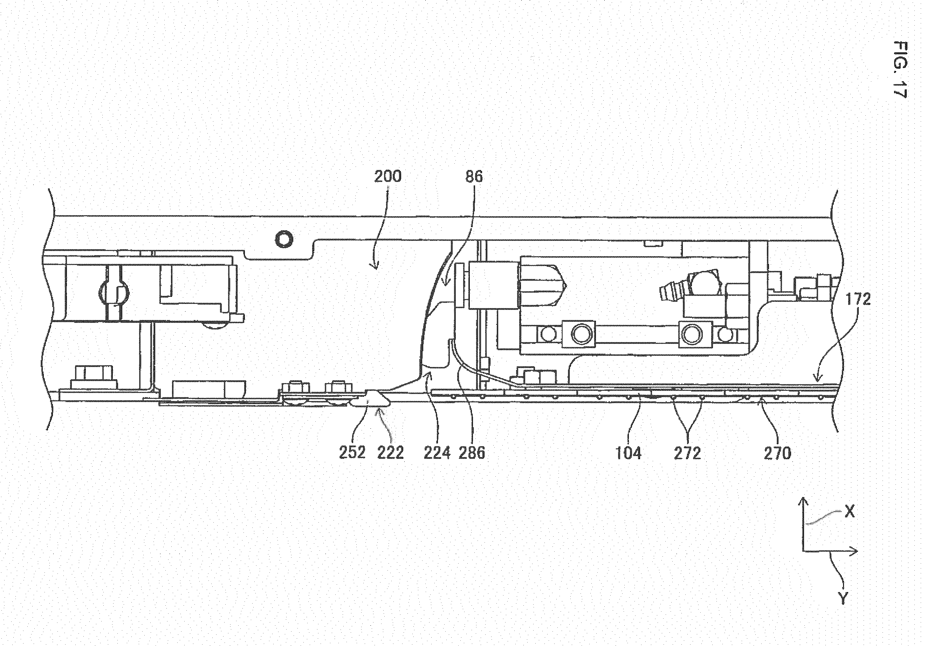

Therefore, in tape feeder 70, as shown in Figs. 13 and 17, curved section 286 is formed at the downstream end of inner wall section 170. Curved section 286 is curved in the direction in which protruding portion 252 of tape inclining member 222 protrudes, that is, in the direction in which waste tape 270 is pushed by tape inclining member 222 and is largely curved toward the downstream side. Curved section 286 is located upstream from the upstream end of tape inclining member 222. In other words, the upstream end of curved section 286 is located upstream from the upstream end of tape inclining member 222 by a distance longer than the length of tape inclining member 222 in the Y-direction. Therefore, when waste tape 270 is pushed toward inner wall section 170 by tape inclining member 222, sliding contact of waste tape 270 with the downstream end of inner wall section 170 is suppressed. This makes it possible to eliminate or reduce the sliding resistance between waste tape 270 and the downstream end of inner wall section 170, thereby suppressing the occurrence of jamming.

Also, even in the case where the above-described countermeasures are taken, the feeding of waste tape 270 may become slightly delayed. In such a case, when the bending line of carrier tape 104 of waste tape 270 is disposed in second straight section 184 of path 178, if the bending line is bent to a large extent, jamming may occur. As described above, as for the cause of carrier tape 104 being bent at the folding line to a large extent, the folding line being positioned in second straight section 184 of path 178, it is possible that the gap between inner wall section 170 and outer wall section 172 defining second straight line section 184 has widened. That is, the space between inner wall section 170 and outer wall section 172 is slightly wider than the thickness of carrier tape 104 but is not wide enough to bend carrier tape 104 to a large extent. Therefore, even if the feeding of waste tape 270 is slightly delayed, carrier tape 104 does not bend greatly at the folding line as long as the distance between inner wall section 170 and outer wall section 172 does not change.

In view of this, in tape feeder 70, inner wall section 170 and outer wall section 172 are fixed to feeder main body 72 at the lower end, and inner wall section 170 and outer wall section 172 are fixedly connected at the upper end. Therefore, even when the feeding of the waste tape 270 is slightly delayed, the distance between inner wall section 170 and outer wall section 172 does not change and is kept constant. This makes it possible to suppress the bending at folding lines of carrier tape 104 positioned in second straight section 184 and suppress the occurrence of jamming.

Further, even if bending at the folding lines of carrier tape 104 in second straight section 184 is suppressed in the case where the feeding of waste tape 270 is slightly delayed, there is a fear that carrier tape 104 may be displaced upward in second straight section 184. As described above, when carrier tape 104 is displaced upward in second straight section 184, second feed claw member 128 disengages from feeding hole 110 of carrier tape 104, resulting in waste tape 270 not being appropriately fed and jamming may occur.

In view of this, in tape feeder 70, a lid is provided at the upper edges of inner wall section 170 and outer wall section 172 that define second straight section 184. More specifically, as shown in Fig. 8, step section 173 that bends toward inner wall section 170 is formed on the upper edge of outer wall section 172 that defines second straight section 184. In step section 173, inner wall section 170 and outer wall section 172 are fastened by multiple bolts 174.

Therefore, step section 173 functions as a lid covering the upper edges of inner wall section 170 and outer wall section 172. The length of second straight section 184 in the up-down direction, that is, the distance between the bottom face of second straight section 184 and step section 173 is slightly larger than the length of waste tape 270 in the width direction. The length of waste tape 270 in the width direction is obtained by adding the length of remaining lead 272 protruding from the upper edge of carrier tape 104 to the length of carrier tape 104 in the width direction. As described above, by providing the lid at the upper edges of inner wall section 170 and outer wall section 172 that define second straight section 184, it is possible to prevent carrier tape 104 from shifting upward in second straight section 184 when the feeding out of waste tape 270 is slightly delayed. This makes it possible to suppress the occurrence of second feed claw member 128 disengaging from feeding hole 110 due to displacement of carrier tape 104, thereby suppressing the occurrence of jamming.

### (D) Discharge of waste tape that has been delivered by the feed device

Further, in tape feeder 70, when all of radial components 102 of taped component 100 are separated from carrier tape 104, waste tape 270 is fed to second straight section 184 by feed device 80 via reversing section 182 of path 178. At this time, first feed claw member 126 and return prevention claw member 130 of feeding device 80 are not engaged with feeding holes 110 of waste tape 270, and only second feed claw member 128 of feeding device 80 is engaged. Therefore, waste tape 270 from which all radial components 102 are separated is fed rearward in second straight section 184 by only second feed claw member 128 of feed device 80 .

When waste tape 270 is fed rearward only by second feed claw member 128, the feeding of waste tape 270 is stopped after waste tape 270 is fed rearward by the engagement of second feed claw member 128 with feeding hole 110 at the downstream end of waste tape 270. That is, when feeding hole 110 at the downstream end of waste tape 270 is fed to the rear of second feed claw member 128, the feeding of waste tape 270 by feeding device 80 is completed, and waste tape 270 stops in a state in which the downstream end remains inside tape feeder 70.

Therefore, when the feeding of waste tape 270 is stopped, the operator pulls waste tape 270 extending from discharge port 278 downward, whereby waste tape 270 is extracted from the inside of tape feeder 70, that is, from second straight section 184 between inner wall section 170 and outer wall section 172. However, waste tape 270 is inserted between tape inclining member 222 and restricting member 224, and the orientation of waste tape 270 is changed from the standing state to the inclined state. That is, between tape inclining member 222 and restricting member 224, waste tape 270 is bent from the standing state to the inclined state.

Therefore, when the operator pulls waste tape 270 extending from discharge port 278, a load is applied to the bent section of waste tape 270, and waste tape 270 cannot be smoothly extracted. In particular, since remaining lead 272 remains in waste tape 270, it is difficult to smoothly extract waste tape 270. Further, when the operator pulls waste tape 270 extending from discharge port 278, waste tape 270 may break, and waste tape 270 may remain in second straight section 184 of path 178 of the tape feeder. Further, when the operator pulls waste tape 270 extending from discharge port 278, remaining lead 272 or the like may break discharging mechanism 86 such as tape inclining member 222 inside tape feeder 70.

In view of this, slit 188 is formed in outer wall section 172 of tape feeder 70 that defines second straight section 184 of path 178. As described above, the tip end of second feed claw member 128 that engages with feeding hole 110 of waste tape 270 is inserted into slit 188 and slightly protrudes to the outside of outer wall section 172 through slit 188. Slit 188 extends, in the front-rear direction, over the entire area of outer wall section 172 that defines second straight section 184. Therefore, many of feeding holes 110 of waste tape 270 inserted into second straight section 184 of path 178 are exposed through slits 188.

Therefore, in tape feeder 70, when the feeding of the waste tape 270 is completed, the operator engages feeding hole 110 of waste tape 270 via slit 188 with a tool having a sharp tip or the like and manually feeds waste tape 270 rearward. At this time, the operator pulls waste tape 270 extending from discharge port 278. That is, waste tape 270 whose feeding by feeding device 80 has been completed is pulled by the operator on the downstream side of discharging mechanism 86 and is fed rearward toward the operator on the upstream side of discharging mechanism 86.

As described above, slit 188 into which second feed claw member 128 is inserted extends in the front-rear direction, and by waste tape 270 being manually fed rearward through slit 188, waste tape 270 is smoothly discharged from the inside of tape feeder 70. This makes it possible to prevent cutting of waste tape 270, damage of discharging mechanism 86, and the like. Further, by smoothly discharging waste tape 270, it is possible to greatly shorten the operation time required for discharging waste tape 270. Specifically, for example, in the case where waste tape 270 is not fed through slit 188, the operation time of discharging waste tape 270 is 5 minutes, but by feeding out waste tape 270 through slit 188, the operation time of discharging waste tape 270 is 1 minute. In other words, by smoothly discharging waste tape 270, it is possible to reduce the work stress of the operator.

Tape feeder 70 is an example of a tape feeder. Taped component 100 is an example of a taped component. Radial component 102 is an example of a lead component. Carrier tape 104 is an example of a carrier tape. Lead 108 is an example of a lead. Inner wall section 170 and outer wall section 172 are examples of wall surfaces. Path 178 is an example of a path. Slit 188 is an example of an opening. Tape inclining member 222 is an example of a pushing section. Waste tape 270 is an example of a waste tape. Remaining lead 272 is an example of a remaining lead. Discharge port 278 is an example of a discharge port. Curved section 286 is an example of a curved section.

In addition, the present invention is not limited to the above-described embodiments, and can be implemented in various modes in which various changes and improvements are made based on the knowledge of a person skilled in the art and within the limits of the appended claims. Specifically, for example, in the above embodiment, the present invention is applied to the discharge of waste tape 270 after radial component 102 is removed, but the present invention may be applied to the discharge of the waste tape after the axial component is removed.

In the above embodiment, the orientation of waste tape 270 is changed by tape inclining member 222 and restricting member 224, but the orientation of waste tape 270 may be changed by tape inclining member 222 without using restricting member 224.

### Reference Signs List

70: Tape feeder, 170: Inner wall section (wall surface), 172: Outer wall section (wall surface), 178: Path, 188: Slit, 222: tape inclining member (pushing section), 270: Waste tape, 272: Remaining lead, 278: Discharge port, 286: Curved section

## Claims

1. A tape feeder (70) configured to supply lead components (102) removed from a carrier tape (104) by cutting leads (108) of a taped component (100), and discharge a waste tape (270) outside of the tape feeder (70), the taped component (100) being composed of the lead components (102), each having the leads (108), and the carrier tape (104) holding the leads (108) of the lead components (102), the waste tape (270) being composed of remaining leads (272), which remain on the carrier tape (104) after the leads (108) are cut, and the carrier tape (104) holding the remaining leads (272) in a protruded state; wherein, the tape feeder (70) further comprises:
a path (178), inside the tape feeder (70), which is used for linearly feeding the taped component (100) before cutting the leads (108) and linearly feeding the waste tape (270) after cutting the leads (108) in a first direction, and then reversing to a second direction opposite to the first direction and linearly feeding in the second direction;
a discharge port (278) configured to discharge the waste tape (270), being fed from the downstream end of the path (178), downwardly from the tape feeder (70); and
a pushing section (222), being provided between the downstream end of the path (178) and the discharge port (278), configured to push a portion of the carrier tape (104) of the waste tape (270) fed from the downstream end of the path (178) in a direction intersecting the path (178)
**characterized in that:**
a slit-shaped opening (188) is formed in a wall surface (170, 172) of a side wall of the tape feeder (70) so as to extend in the second direction of the waste tape (270), the wall surface (170, 172) being one among a pair of wall surfaces (170, 172) defining the path (178) configured to feed the waste tape (270) in the second direction; and multiple feeding holes (110) of the carrier tape (104) of the waste tape (270) are exposed through the opening (188).

2. The tape feeder (70) of claim 1, wherein the wall surface (170, 172), defining the path (178) configured to feed the waste tape (270) in the second direction, curves toward the direction in which the waste tape (270) is pushed by the pushing section (222).

## Patentansprüche

1. Ein Bandzuführer (70), der konfiguriert ist Leitungskomponenten (102) zuzuführen, die von einem Trägerband (104) durch Schneiden von Leitern (108) einer gegurteten Komponente (100) entfernt wurden, und ein Abfallband (270) außerhalb der Bandzuführvorrichtung (70) abzuführen, wobei die gegurtete Komponente (100) aus den Leitungskomponenten (102), die jeweils die Leiter (108) aufweisen, und dem Trägerband (104), das die Leitungen (108) der Leitungskomponenten (102) hält, zusammengesetzt ist, wobei das Abfallband (270) aus verbleibenden Leitungen (272) zusammengesetzt ist, die auf dem Trägerband (104) verbleiben, nachdem die Leitungen (108) geschnitten wurden, und das Trägerband (104) die verbleibenden Leitungen (272) in einem vorstehenden Zustand hält; wobei der Bandzuführer (70) ferner umfasst:
einen Pfad (178) innerhalb des Bandzuführers (70), der zum linearen Zuführen der mit Band versehenen Komponente (100) vor dem Schneiden der Leitungen (108) und zum linearen Zuführen des Abfallbandes (270) nach dem Schneiden der Leitungen (108) in einer ersten Richtung und dann zum Umkehren in eine zweite Richtung entgegengesetzt zur ersten Richtung und zum linearen Zuführen in der zweiten Richtung verwendet wird;
eine Ausgabeöffnung (278), die konfiguriert ist das Abfallband (270), das von dem stromabwärts gelegenen Ende des Pfades (178) zugeführt wird, nach unten von dem Bandzuführer (70) auszugeben; und
einen Schiebeabschnitt (222), der zwischen dem stromabwärtigen Ende des Pfades (178) und der Ausgabeöffnung (278) angeordnet ist und konfiguriert ist einen Teil des Trägerbandes (104) des Abfallbandes (270), das von dem stromabwärtigen Ende des Pfades (178) zugeführt wird, in eine Richtung zu schieben, die den Pfad (178) schneidet
**gekennzeichnet dadurch dass:**
eine schlitzförmige Öffnung (188) in einer Wandfläche (170, 172) einer Seitenwand der Bandzuführung (70) so ausgebildet ist, dass sie sich in der zweiten Richtung des Abfallbandes (270) erstreckt, wobei die Wandfläche (170, 172) eine von einem Paar von Wandflächen (170, 172) ist, die den Pfad (178) definieren, der konfiguriert ist das Abfallband (270) in der zweiten Richtung zuzuführen; und mehrere Zuführungslöcher (110) des Trägerbandes (104) des Abfallbandes (270) durch die Öffnung (188) freizulegen.

2. Der Bandzuführer (70) gemäß Anspruch 1, wobei
die Wandfläche (170, 172), die den Pfad (178) definiert, der konfiguriert ist das Abfallband (270) in der zweiten Richtung zuzuführen wird, sich in die Richtung krümmt, in die das Abfallband (270) durch den Schiebeabschnitt (222) geschoben wird.

## Revendications

1. Dispositif d'alimentation en bande (70) configuré pour délivrer des composants à pattes (102) retirés d'une bande porteuse (104) en coupant des pattes (108) d'un composant sur bande (100), et pour évacuer une bande rebut (270) à l'extérieur du dispositif d'alimentation en bande (70), le composant sur bande (100) étant constitué des composants à pattes (102), chacun comportant les pattes (108) et la bande porteuse (104) supportant les pattes (108) des composants à pattes (102), la bande rebut (270) étant constituée des pattes restantes (272) qui subsistent sur la bande porteuse (104) après la découpe des pattes (108), et la bande porteuse (104) supportant les pattes restantes (272) à l'état saillant ; le dispositif d'alimentation en bande (70) comprenant en outre :
une ligne (178) à l'intérieur du dispositif d'alimentation en bande (70), laquelle est utilisée pour délivrer linéairement le composant sur bande (100) avant de couper les pattes (108) et pour délivrer linéairement la bande rebut (270) après avoir coupé les pattes (108) dans un premier sens, et par inversion ensuite dans un second sens opposé au premier sens et en délivrant linéairement dans le second sens,
un orifice d'évacuation (278) configuré pour évacuer la bande rebut (270) délivrée depuis l'extrémité aval de la ligne (178) vers le bas depuis le dispositif d'alimentation en bande (70), et
une section de poussée (222) disposée entre l'extrémité aval de la ligne (178) et l'orifice d'évacuation (278), configurée pour pousser une partie de la bande porteuse (104) de la bande rebut (270) délivrée depuis l'extrémité aval de la ligne (178) dans une direction coupant la ligne (178),
**caractérisé en ce que** :
une ouverture en forme de fente (188) est formée dans la surface de paroi (170, 172) d'une paroi latérale du dispositif d'alimentation en bande (70) de sorte à s'étendre dans le second sens de la bande rebut (270), la surface de paroi (170, 172) étant l'une parmi une paire de surfaces de paroi (170, 172) définissant la ligne (78) configurée pour délivrer la bande rebut (270) dans le second sens ; et de multiples trous de distribution (110) de la bande porteuse (104) de la bande rebut (270) sont apparents au travers de l'ouverture (188).

2. Dispositif d'alimentation en bande (70) selon la revendication 1, dans lequel :
la surface de paroi (170, 172) définissant la ligne (178) configurée pour délivrer la bande rebut (270) dans le second sens, s'incurve dans la direction dans laquelle la bande rebut (270) est poussée par la section de poussée (222) .
